# EUROPEAN PATENT APPLICATION

(11) **EP 4 394 895 A1**
(43) Date of publication of application: **03.07.2024**
(21) Application number: 22217406.2
(22) Date of filing: 30.12.2022
(51) Int. Cl.: H01L 31/042, H02S 30/10

(54) **PHOTOVOLTAIC SANDWICH PANEL, PARTICULARLY PV VEHICLE CLADDING SANDWICH PANEL, WITH HONEYCOMB-FRAME BACK STRUCTURE AND MANUFACTURING METHOD**

(71) Applicant: Sono Motors GmbH, 80935 München (DE)
(72) Inventor: RAMESHA, Harshan, 09119 Chemnitz (DE); HECKER, Carsten, 85560 Ebersberg (DE); SPYRA, Tim, 82069 Hohenschäftlarn (DE); KAPP, Camillo, 80992 München (DE)
(74) Representative: Qip Patentanwälte Dr. Kuehn & Partner mbB

(57) **Abstract**

A photovoltaic sandwich panel 1, particularly photovoltaic vehicle cladding sandwich panel, is present and comprises a sheet-like photovoltaic label 3 and a back structure 5. The photovoltaic label 3 comprises at least a front side polymeric lamination foil 11, a rear side polymeric lamination foil 13 and a solar cell arrangement 17 interposed between the front and rear side lamination foils 11, 13. The photovoltaic label 3 is fixed with its rear side to a front side of the back structure 5. The back structure 5 comprises a honeycomb structure 18 and a frame structure 22 in one piece. The frame structure 22 predominantly frames an outer edge of the honeycomb structure 18, and the honeycomb structure 18 is arranged predominantly abutting to an area of the photovoltaic label 3 which comprises a solar cell arrangement 17. The frame structure 22 further comprises a pocket structure 24 which is arranged predominantly abutting to a circumferential outer edge of the photovoltaic label 3 outside the solar cell arrangement 17.

Furthermore, a method for manufacturing a photovoltaic sandwich panel 1 is presented.

## Description

### FIELD OF THE INVENTION

The present invention relates to a sandwich panel, particularly to a vehicle cladding sandwich panel, and to a method for manufacturing such sandwich panels.

### TECHNICAL BACKGROUND

In the following, the term "photovoltaic" may be abbreviated by "PV". PV cells may also be referred to as solar cells. The term "vehicle cladding sandwich panel" may refer to a panel which may be included in and/or attached to a body of any kind of vehicles such as cars, trucks, trailers, busses, mobile homes, trains, ships, airplanes, etc.

Most commercially available PV panels are produced with rigid wafer-based solar cells that are embedded in a polymer encapsulation which is covered at its front side by a glass sheet and at its rear side by a support structure. Such PV panels are generally heavy and relatively cost-intensive. Furthermore, such PV panels are generally planar.

Such planar PV panels are hardly suited for an integration into curved surfaces such as for example surfaces of body panels of a car or another vehicle.

Approaches have been presented in which PV cells are provided at a body of a car, for generating electricity to be supplied to the car. Such electricity may be used for example for charging batteries of an electric car.

It has been proposed by the present applicant in an earlier patent application WO 2020/187792 A1 to integrate a solar cell arrangement into a moulded layer formed by injection moulding. Therein, the solar cell arrangement is interposed between polymeric foils, thereby forming a so-called photovoltaic label which may be securely handled and in which the solar cells are for example protected against excessive mechanical stress during an injection moulding procedure. Further approaches for a car body panel comprising an integrated solar cell arrangement have been proposed by the present applicant in earlier patent applications WO 2022/122507 A1 and DE 10 2022 101 935 A1, the latter one describing a use of reaction injection moulding techniques for PV panel production. Possible features and characteristics of such approaches of car body panels and approaches for fabricating a car body panel including a photovoltaic module have been described by the applicant in the above mentioned patent applications as well as in further prior patent applications such as WO 2021/260021 A1 (title: "Method for fabricating a photovoltaic module including laser cutting of a photovoltaic label"), WO 2021/260024 A1 (title: "Method for fabricating a curved photovoltaic module including adapted positioning of photovoltaic cells") and DE 10 2022 108 014 A1 (title "Method for fabricating a Photovoltaic Module using In-Mould Labelling with specific Temperature Management"). Another approach for a car body panel comprising an integrated solar cell arrangement has been proposed by the present applicant in earlier patent application WO 2022/122507 A1, having the title "Car body panel including a solar cell arrangement and method for producing same". Furthermore, EP 22 189 888 A1 discloses a connector for a PV panel in a vehicle.

In each of these prior art approaches, the car body panel including the solar cell arrangement may be regarded as a photovoltaic module having a non-planar shape. A body panel of a vehicle including an integrated PV module may be referred to herein as PV integrated car body panel.

Nevertheless, the development and production of these PV sandwich panels, particularly PV integrated vehicle cladding sandwich panels, still has several challenges such as keeping the solar body panel as light weight as possible, bringing, and keeping the PV label in a desired shape, or ensuring a certain stiffness of the solar body panel to withstand e.g. automotive load cases. Furthermore, the panel should allow for some flexibility to a certain extent e.g. during bending, thermal expansion, etc. Particularly in automotive appliances, structural characteristics of the PV sandwich panel may have to be adapted such as to pass e.g. pedestrian protection requirements. In certain cases, enough free space for positioning tolerances of e.g. connection boxes for electrical connection and indicating its orientation should be provided. Furthermore, interface surfaces such as for gluing other parts to the back structure may have to be created. Overall, the PV sandwich panel should be producible on an industrial scale, at low costs and/or with high reliability.

### SUMMARY OF THE INVENTION AND OF EMBODIMENTS

In the following, a PV sandwich panel, particularly a PV integrated vehicle cladding sandwich panel, and a method for manufacturing the same are disclosed, which may achieve at least some of the above mentioned desired characteristics.

According to a first aspect of the present invention, a photovoltaic sandwich panel, particularly photovoltaic vehicle cladding sandwich panel, is disclosed, comprising at least one sheet-like photovoltaic label and a back structure. The at least one photovoltaic label comprises at least a front side polymeric lamination foil, a rear side polymeric lamination foil and a solar cell arrangement interposed between the front and rear side lamination foils. The at least one photovoltaic label is fixed with its rear side to a front side of the back structure. The back structure comprises a honeycomb structure and a frame structure in one piece. The frame structure predominantly frames an outer edge of the honeycomb structure. The honeycomb structure is arranged predominantly abutting to an area of the at least one photovoltaic label which comprises the solar cell arrangement. The frame structure further comprises a pocket structure which is arranged predominantly abutting to a circumferential outer edge of the at least one photovoltaic label outside the solar cell arrangement.

According to a second aspect of the present invention, a method for manufacturing a photovoltaic sandwich panel, particularly a photovoltaic car body panel, is presented. The method includes at least the following steps, preferably in the indicated order:
- providing a reversibly closable mould with a cavity formed by a first mould part and a second mould part, suitable for injection moulding,
- inserting at least one sheet-like photovoltaic label into the first part of the mould, the at least one photovoltaic label comprising a front side polymeric lamination foil, a rear side polymeric lamination foil and a solar cell arrangement interposed between the front and rear side lamination foils,
- closing the mould via pressing the first mould part and the second mould part together and thereby fixing the at least one sheet-like photovoltaic label between the first and second mould parts of the mould by applying a frictional connection to the photovoltaic label, wherein the frictional connection is basically applied by multiple pocket-stamps positioned in a circumferential frame area, at a circumferential outer edge of the at least one photovoltaic label outside the solar cell arrangement,
- injecting a viscous polymer material into the cavity and onto the at least one photovoltaic label and subsequently solidifying the polymer material, thereby creating and fixing a back structure to the photovoltaic label, the back structure comprising a honeycomb structure, at areas of the at least one photovoltaic label which comprise the solar cell arrangement, and comprising a frame structure, at parts of the photovoltaic label outside solar cell arrangement, wherein the frame structure is arranged at the circumferential outer edge of the photovoltaic label.

Briefly summarized and without limiting the scope of the invention, basic ideas underlying embodiments of the invention and associated possible advantages will be roughly described as follows: Due to the inventive combination of a flexible PV label and an integrated back structure containing a honeycomb structure, a frame structure and a pocket structure, a lightweight and robust PV sandwich panel, particularly a lightweight and robust PV vehicle cladding sandwich panel, may be achieved. Therein, the entire back structure may be produced in a single polymer moulding process forming the honeycomb structure as well as the frame structure with its included pocket structure in a single injection moulding step using a mould with at least two mould parts (wherein the mould may comprise further mould parts such as sliders). Particularly, the frame structure is arranged at a circumference of the back structure in an area close to the circumferential edge of the PV label and at least partially overlaps an edge region of the PV label where no solar cells are embedded between the polymeric foils of the PV label. At such circumferential area, pocket stamps provided at one or both of the mould parts may generate a frictional connection for fixing the PV label during high pressurised polymeric injection into the cavity formed between the two mould parts. Accordingly, the PV label is reliably held fixed relative to the mould parts. The areas where the pocket stamps contact and cover the PV label during polymeric injection form the pocket structure in the frame structure of the final PV sandwich panel. Particularly, the pocket stamps and the resulting pocket structure are arranged at locations of the PV label outside the solar cell arrangement, i.e. close to the circumferential edge of the PV label where the PV label comprises only the polymeric foils but with no solar cells being locally interposed between these foils. The width of the frame structure and the size, arrangement and design of the pocket structure achieves a save fixation of the PV label to the back structure, even at e.g. highly 3-D curved car body panels. The combination of the honeycomb structure laterally enclosed by the frame structure, on the one hand, and the PV label attached thereto, on the other hand, allows an energy producing car body panel, which allows achieving various requirements regarding e.g. panel stiffness, low panel weight and adapted mechanical panel properties to realise e.g. pedestrian protection in automotive applications.

In the following, possible features of embodiments of the invention and associated possible advantages will be described in more detail.

The term back structure comprises any kind of supporting structure suitable to physically stabilise the photovoltaic label and give the photovoltaic sandwich panel its needed structural characteristics and shape. Generally, the PV label is bendable and does not offer all the needed structural characteristics, like stiffness, self-supporting properties, etc. Therefore, the back structure is an essential part of the photovoltaic sandwich panel which ensures the needed structural performances in various application fields such as crash-characteristics or pedestrian protection for PV vehicle body panels. The back structure is made as a single unitary component. Specifically, the back structure including its honeycomb structure and its frame structure are made with the same polymer material and may generally be formed in a common injection moulding process. In a specific implementation, such injection moulding process may be embodied as reaction injection moulding (RIM) process using thermosetting polymer material. The back structure is fixed to the PV label preferably via a positive substance jointing connection. Preferably, the PV label and the back structure comprise a same polymer or are made with polymer mixtures sharing at least one common polymer component. Preferably, the back structure abuts directly to a surface of the PV label, i.e. with no intermediate layer (such as a primer layer) being interposed there between.

The term "honeycomb structure" relates to structures that have the geometry of a honeycomb to allow the minimization of the amount of used material to reach minimal weight and minimal material cost. The geometry of honeycomb structures can vary widely but the common feature of all such structures is an array of hollow cells formed between thin vertical side walls. The cells are often columnar and may be hexagonal or quasi-hexagonal in shape. The honeycomb structure may be provided with a mesh size corresponding to an inner dimension or diameter of each honeycomb, a rib width corresponding to a thickness of the honeycomb's side walls and a rip height corresponding to a height of the honeycomb's side walls. A honeycomb shaped structure provides a material with minimal density and relative high out-of-plane compression properties and out-of-plane shear properties. The term "honeycomb structure" as used herein should not be limited to hexagonal formed combs. Other comb geometries like round, oval, triangular or quadrangular should be included. Preferably, the honeycomb structure does not offer a back wall which is part of the back structure. In other words, the honeycombs are closed on its front side only by the attached back side of the photovoltaic label. As an alternative, the honeycomb structure may include a thin interface layer extending continuously along the back side of the photovoltaic label. Such interface layer generally has a thickness being significantly smaller than a rib height of the honeycomb structure, i.e. having a thickness of less than 20%, preferably less than 10 % of the rib height of the honeycomb structure, e.g. a thickness of less than 0.3 mm or less than 0.2 mm. Such interface layer may increase an adhesion between the honeycomb structure and the back side surface of the PV label. Furthermore, it may be noted that the geometry, i.e. the mesh size, rib height and/or rib width may vary along the honeycomb structure throughout the extension of the PV label.

"Front side" is defined as the side of components which is dedicated to be directed towards the sun when the PV integrated car body panel is in action of producing energy. Back side is the opposite direction to this front side.

The frame structure is characterised in that it surrounds the honeycomb structure at its outer edge. In other words, the frame structure may form a ring enclosing the honeycomb structure. The width of the frame structure is generally broader than the width of the side walls of the honeycomb structure. Preferably, the width of the frame is at least double or at least triple the width of the side walls of the honeycomb structure. By this, a contact area between the back structure and the PV label is larger at the frame structure than at the honeycomb structure. This ensures superior adherence of the PV label to the back structure particularly along its circumferential frame structure, i.e. that the PV label is properly fixed at its outer edge to the back structure and thereby does not separate or delaminate from it. Especially, PV integrated car body panels with high 3-D curvature may require a broader frame structure. The width of the frame structure may be adapted to the geometry of the PV integrated car body panel to prevent separation.

The pocket structure is characterised in that it includes multiple pockets being arranged circumferential along an outer edge of the PV label. Each pocket may be formed by a partial area in the frame structure where no polymer material locally covers the adjacent PV label, i.e. by a local through-opening in the frame structure. The pockets are arranged in the frame structure not in the honeycomb structure. The honeycombs are basically arranged in a matrix structure, which means, that every honeycomb is basically surrounded by several other neighbouring honeycombs in several directions. In contrast hereto, the pockets are generally arranged in a linear, chain like formation, which means, that every pocket basically borders to two neighbouring pockets. Preferably, the pockets are formed long drawn-out around the outer edge of the PV label. That means, that the length of the pockets is preferably at least double the size of its width. The pockets are designed to surround an entire portion of the PV label incorporating the solar cell arrangement in a ring like manner. Preferably, the pockets have a length of approximately 30 mm and the distance between two neighboured pockets in the frame is approximately 3mm. This 3mm stage between neighbouring pockets may be referred to as "runner" and may be needed to ensure a sufficient flow of moulding polymer during the manufacturing process. Depending on the integration technology this stage width or runner width may be increased accordingly.

The term "predominantly" as used herein may indicate that at least 50%, preferably at least 70%, 80% or even 90%, of the related feature is formed like described. The term "approximately" as used herein may indicate that up to +/-10 or even up to +/-20 percent of the related feature is formed like described.

Larger car body panels and/or highly curved 3-D geometries often require more than one PV label fixed to the back structure. Using several PV labels at one back structure may achieve a large area coverage with solar cells. The above-mentioned disclosure of the arrangement of the frame and the pocket structure is then accordingly adapted to each PV label. In other words, if the car body panel comprises several PV labels fixed to one back structure, each PV label comprises its one frame and pocket structure each arranged circumferential to the outer edge of the related PV label.

According to an embodiment, the photovoltaic sandwich panel comprises a honeycomb structure designed with a mesh size of approximately 30 mm diameter, approximately 3.0 mm rib width and approximately 3.7 mm rib height. This dimension was found as a trade-off between several desired part properties. It is a trade-off between minimizing the parameter mesh size, maximising the rib width and rib height, to increase adhesion contact between back structure PV label. A high stiffness of the car body panel is achieved with decreased weight and sufficient flexibility.

According to an alternative embodiment, the photovoltaic sandwich panel comprises a honeycomb structure designed with a mesh size of approximately 40 mm diameter, approximately 3.0 mm rib width and approximately 3.0 mm rib height. The parameters of the aforementioned embodiment might not be suitable for a PV vehicle cladding sandwich panel which shall serve e.g. as hood of a vehicle and which shall therefore satisfy pedestrian protection requirements, especially because it might be too stiff and excessively injure a pedestrian in case of an accident. The pedestrian protection requirements would be met according to simulations with the mesh dimensions of this alternative embodiment. These dimensions could not be applied to body parts of the vehicle other than the hood, as they might then not meet the specific stiffness requirements.

According to an embodiment, the photovoltaic sandwich panel comprises a honeycomb structure with at least one cut-out in a honeycomb mesh. Such a cut-out may be necessary to install an electric connection to the solar cell arrangement at this place. For example, electrical connection boxes need to be glued and soldered to contact points at the PV label. Preferably, the cut-out in the honeycomb structure basically offer the same outer shape as the related connection box, to ensure that assembly workers cannot attach the connection box in a wrong orientation. Furthermore, a lateral extension or size of the cut-out may be slightly larger than dimensions of the connection box to be arranged therein in order to e.g. allow predefined positioning tolerances.

According to an embodiment, the photovoltaic sandwich panel comprises at least one honeycomb cell which is filled up and thereby is one piece with the back structure. In some places, brackets or other parts or components may need to be glued to the back structure in a place where the honeycomb mesh would hinder it. The locally filled-up honeycomb mesh may provide a proper connection surface.

Preferably, the frame structure further comprises areas with interface geometries such as locator pins. The pocket structure may be accordingly adapted and e.g. extended around these interfaces.

According to an embodiment, the frame structure has a frame width of at least 10 mm, preferably at least 20 mm. For example, the frame structure may have a frame width of between 10 mm and 50 mm, preferably between 15 mm and 30 mm. Due to its material and/or structural characteristics, the PV label tends to get back in its original flat shape. This must be prevented by the back structure to keep it in a desired 3D formed curved shape. Especially in the outside perimeter of the PV label, the pull-back forces are high. It must be ensured that the adhesion between the back structure and PV label is strong enough. This can be achieved by increasing the adhesion surface to e.g. approximately 20 mm at the frame structure.

Upon manufacturing the PV sandwich panel in accordance with the second aspect of the invention, during the process of injection moulding, viscous polymer material such as hot molten plastics is injected at high pressures into a cavity formed between two mould parts of a reversibly closable mould. In a preceding step, the PV label has been fixed between the mould parts, i.e. at the cavity. The viscous polymer will flow along the PV label and may potentially push it away from the intended position within the mould. Therefore, the PV label must be kept in place. Furthermore, no viscous polymer should reach the front side of the PV label with its solar cells. If viscous polymer would overlap the solar cells at the front side, the cells efficiency would be reduced, because the sunlight could not reach 100% of the cells anymore. Furthermore, excess polymer material at the front side could deteriorate a visual appearance of the PV label. A solution for this task is the production process described herein. Therein, the PV label is fixed via multiple pocket-stamps positioned in a circumferential frame area, at a circumferential outer edge of the photovoltaic label outside the solar cell arrangement. These pocket-stamps on the mould are approximately 0,1 mm - 0,2 mm higher, i.e. protrude into the cavity between the two mould parts further, than the honeycomb-stamps designed to create the honeycomb structure. In other words, the PV label is pressed with higher force to the mould at the circumferential outer edge, by the pocket-stamps. Due to the increased height of the pocket-stamps, the PV label is locally compressed between the pocket-stamps and a counterpart surface, wherein such compression should be limited to only elastically deforming the PV label but not plastically deforming or even damaging the PV label. It is important, that the high pressure of the pocket-stamps is only applied to the PV label in an area which is arranged predominantly abutting to a circumferential outer edge of the photovoltaic label outside the solar cell arrangement. Otherwise, the pocket-stamp pressure could break the sensible solar cells. Whereas the honeycomb structure is produced predominantly abutting to an area of the photovoltaic label which comprises a solar cell arrangement. By this, the flexible PV label is strengthened to achieve desired structural characteristic for the PV sandwich panel. The honeycomb-stamps generally are adapted such as to apply a significantly lower pressure to the PV label as compared to the pocket-stamps in order to avoid breaking the cells.

When the production process is finished and the mould including its pocket-stamps and honeycomb-stamps is removed, the pocket structure appears in the pocket-stamp areas of the mould. The honeycomb structure appears in the honeycomb-stamp areas of the mould.

Preferably, the back structure including the honeycomb structure and the frame structure is created with a single common injection of viscous polymer material into the cavity of the mould.

It shall be noted that possible features and advantages of embodiments of the invention are described herein partly with respect to a PV sandwich panel, partly with respect to specific applications thereof and partly with respect to a method for manufacturing such PV sandwich panel. One skilled in the art will recognize that the features may be suitably transferred from one embodiment to another, and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 schematically shows a perspective partial view of a photovoltaic sandwich panel according to an embodiment of the invention.
Fig. 2 schematically shows a cross-sectional view of the photovoltaic sandwich panel according to Fig. 1.
Fig. 3 schematically shows a perspective view of a cut-out of a photovoltaic sandwich panel according to another embodiment of the invention.
Fig. 4 schematically shows a perspective view of a photovoltaic sandwich panel according to an embodiment of the invention, containing a couple of honeycomb meshes filled up with the material of the back structure.
Fig. 5 schematically shows a perspective view of a photovoltaic sandwich panel according to another embodiment of the invention, containing three PV labels each surrounded with a frame structure and a pocket structure and an interface geometry arranged between.
Fig. 6 schematically shows a mould used for manufacturing a photovoltaic sandwich panel according to an embodiment of the invention.

The figures are only schematic and not to scale. Same reference signs refer to same or similar features.

### DESCRIPTION OF PREFERRED EMBODIMENTS

In the following, some exemplary embodiments of a photovoltaic sandwich panels 1 are described in detail.

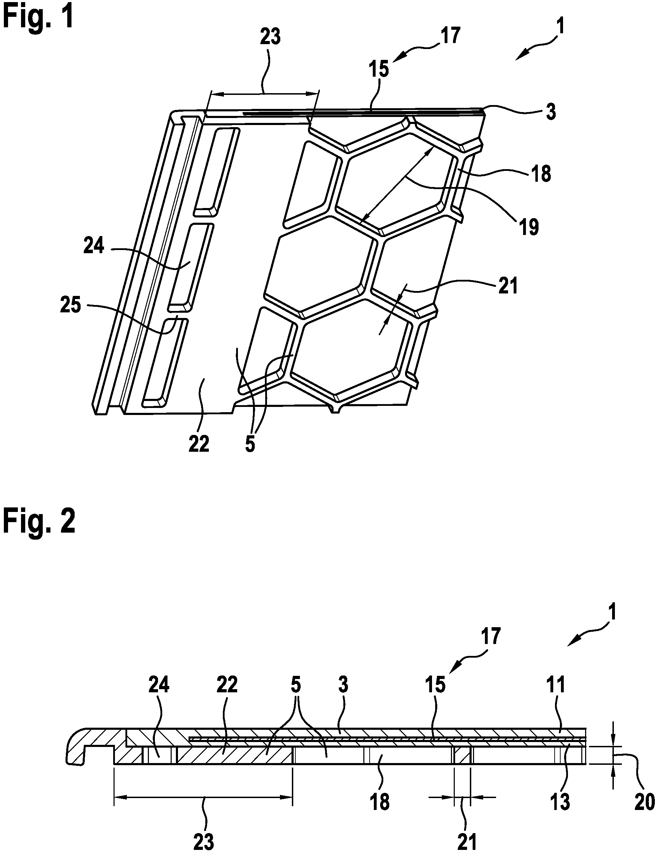

Fig. 1 schematically shows a perspective view of a portion of the photovoltaic sandwich panel 1 according to a first embodiment of the invention. Fig. 2 schematically shows a cross-sectional view of a portion of the photovoltaic sandwich panel 1 according to Fig. 1.

The PV sandwich panel 1 comprises a sheet-like PV label 3 and a back structure 5 in one piece. The PV label 3 comprises a multiple wafer-based solar cells 15 being interconnected to form a solar cell arrangement 17, this solar cell arrangement 17 being embedded in a stack including polymeric lamination foils and, optionally, polymeric stabilisation foils. The back structure 5 comprises a honeycomb structure 18 and a frame structure 22 with a pocket structure 24 included therein.

The PV sandwich panel 1 may have a nonplanar shape, i.e. may have a surface which is curved in one or two dimensions. For example, the PV sandwich panel 1 may be a hood or any other part of a vehicle body. The PV sandwich panel 1 comprises the sheet-like PV label 3 and a back structure 5, the back structure 5 being integrally attached to the PV label 3 such as to provide sufficient stability and rigidity to support the PV label 3 to thereby generate the PV sandwich panel 1 with a sufficient degree of self-supporting characteristics.

The photovoltaic label 3 comprises at least a front side polymeric lamination foil 11, a rear side polymeric lamination foil 13 and the solar cell arrangement 17 interposed between the front and rear side lamination foils 11, 13. Additionally, the PV label 3 may comprise further polymeric foils forming stabilisation foils and covering the lamination foils 11, 13 at their front and/or rear side. Such stabilisation foils may have a higher thickness, a lower bendability and/or stronger mechanical characteristics compared to the lamination foils 11, 13 in order to provide additional mechanical protection to the solar cell arrangement 17 included in the PV label 3. Accordingly, the lamination foils 11, 13 and, optionally, stabilisation foils protect and stabilise the sensitive solar cells 15. Nevertheless, the photovoltaic label 3 is still flexible in a certain manner and not generally suitable to be used as a self-supported car body part.

Therefore, the PV label 1 is fixed with its rear side to a front side of the back structure 5. The rear side is the side of the PV label 3 which shall be directed away from the sun, when the PV label 3 is in action of producing electric solar energy. The back structure 5 comprises the honeycomb structure 18 and the frame structure 22 being integrally comprised in one piece. The frame structure 22 predominantly frames an outer edge of the honeycomb structure 18. The honeycomb structure 18 is arranged predominantly abutting to an area of the photovoltaic label 3 which comprises the solar cell arrangement 17.

In other words, the flexible PV label 3 is fixed to the back structure 5 to achieve the needed structural characteristic for the related car body part. The needed structural characteristic can be stiffness for construction issues, flexibility for pedestrian protection and/or energy absorbing crash behaviour. A certain stiffness may also allow some thermal expansion. The frame structure 22 surrounds the honeycomb structure 18 as well as the solar cell arrangement 17, to additionally stabilize it at its outer edge. Furthermore, the frame structure 22 is needed, to properly fix the PV label 3 to the back structure 5 at its outer edge. 3-D formed car body panels may include a risk of delamination of the PV label 3 from the back structure 5, especially in the outer edge area, as stretch forces and/or strain forces are generally notably higher at such outer edge area. The arrangement of the circumferential frame structure 22 prevents this delamination because the frame structure 22 is significantly broader than a rib width 21 of walls of the honeycomb structure 18 and therefore provides a larger contact area for fixation between the back structure 5 and the PV label 3. Therein, "significantly" means at least two times broader but may include also five times broader or even more.

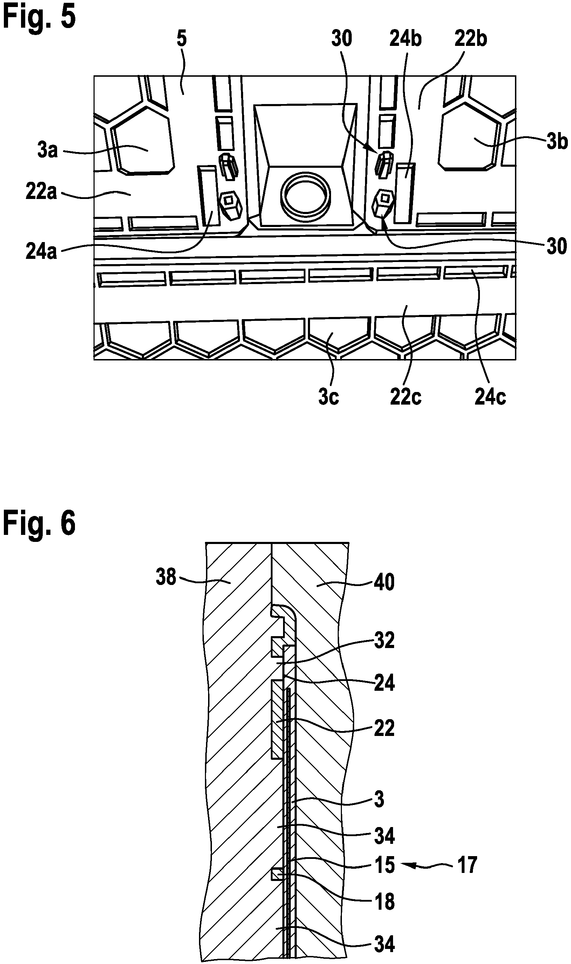

The frame structure 22 further comprises the pocket structure 24 which is arranged predominantly abutting to a circumferential outer edge of the PV label 3 outside the solar cell arrangement 17. The pocket structure 24 is a result of a production process for manufacturing the photovoltaic sandwich panel 1 (as described in more detail below with reference to Fig. 6). In such production process, the PV label 3 may be fixed via pocket-stamps 32 to a mould and therefore allow an injection moulding process which does not displace the PV label 3. In other words, the pocket structure 24 ensures, that the PV label 3 is positioned at its right place regarding the photovoltaic sandwich panel 1. Furthermore, the pocket structure 24 ensures, that during the injection moulding process no hot melted plastic will flow around to the front side of the PV label 3 and therefore cover and shadow the solar cells 15 on the sunlight receiving side.

In other words, the combination of PV label 3 and back structure 5, including honeycomb structure 18, frame structure 22 and pocket structure 24 allows to provide an electric energy producing and custom fitted photovoltaic sandwich panel 1, offering the needed structural characteristics like stiffness or sufficient pedestrian protection.

In the first embodiment of the invention shown in Fig. 1 and Fig. 2, the photovoltaic sandwich panel 1 comprises a honeycomb structure 18 designed with a mesh size 19 of approximately 30 mm diameter, a rib width 21 of approximately 3.0 mm and a rip height 20 of approximately 3.7 mm. These dimensions allow a lightweight structure which still offers the needed stiffness and sufficient flexibility for the photovoltaic sandwich panel 1. Preferably, the frame structure 22 has a frame width 23 of approximately 31 mm. Therein, the frame structure 22 includes the pocket structure 24 included therein. A width of a portion of the frame structure 22 between an inner edge of the frame structure 22 and an inner edge of the pocket structure 24 may be approximately 20 mm. At this size of the frame structure 22, the adhesion between the back structure 5 and PV label 3 is strong enough to avoid delamination.

As shown in Fig. 1 and Fig. 2, the pocket structure 24 is placed circumferential in relation to an outer edge of the PV label 3. The pockets structure 24 is placed in the frame structure 22 not in the honeycomb structure 18. The pockets structure 24 comprises multiple pockets. Such pockets may be interpreted as through-openings extending via the frame structure 22. The pockets are basically arranged in a linear, chain-like structure, which means that every pocket basically borders to two neighbour pockets. The pockets are formed long drawn-out around the outer edge of the PV label 3. The pockets are designed to surround the whole PV label 3 in a ring like manner. The pockets have a length of approximately 27 mm and the distance between two neighbouring pockets in the frame structure 22 is approximately 3 mm. This 3 mm stage between the pockets forms so-called runners 25 and is generally needed to ensure a sufficient polymeric mould flow during the manufacturing process.

In an alternative second embodiment, the general structure of the PV sandwich panel 1 is similar to the one shown in Fig. 1 and Fig. 2. However, as a difference to the preceding first embodiment, the PV sandwich panel comprises a honeycomb structure 18 designed with a mesh size 19 of approximately 40 mm diameter, approximately 3.0 mm rib width 21 and approximately 3.0 mm rip height 20. The parameters are suitable adapted for passing pedestrian protection requirements especially at the hood of a vehicle. The parameters of the first embodiment would make the PV sandwich panel 1 too stiff and therefore might excessively increase a risk of injuring a pedestrian in case of an accident. With the parameters of the second embodiment the pedestrian protection requirements may be obtained. Nevertheless, these dimensions could at least in some cases not be applied to parts of the vehicle other than the hood, as they would then not meet the specific stiffness requirements.

Preferably, the frame structure 22 of the second embodiment has a frame width of approximately 20 mm. Analog to the first embodiment, at this size of the frame structure 22, the adhesion between the back structure 5 and PV label 3 is strong enough to avoid delamination. Preferably, the arrangement and size of the pocket structure 24 of the second embodiment is equal or similar to the first embodiment.

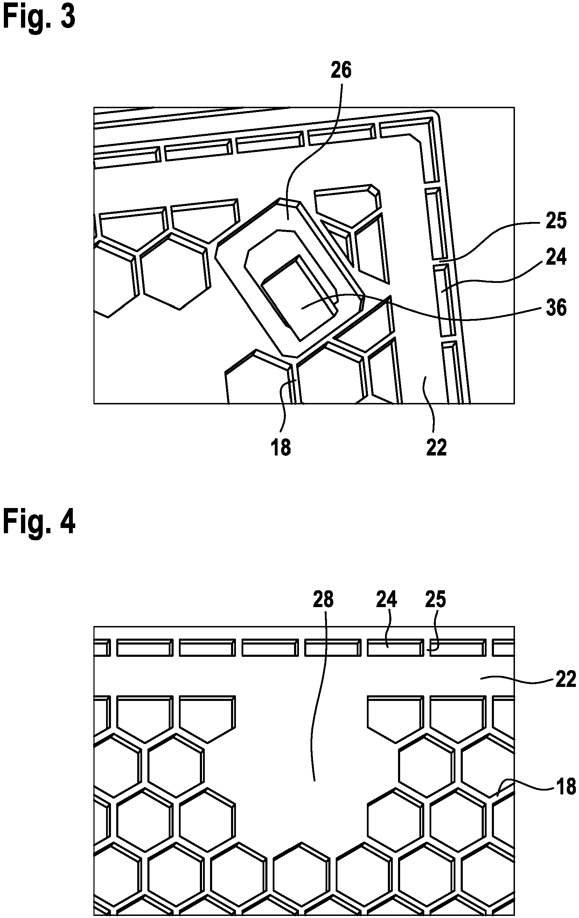

Fig. 3 shows a constructive adaptation of a photovoltaic sandwich panel 1. According to this embodiment of the invention, the honeycomb structure 18 comprises at least one cut-out 26 in a honeycomb mesh. Such a cut-out 26 may be necessary to install an electric connection to the solar cell arrangement 17 at this place. As shown in Fig. 3, an electrical connection box 36 is soldered to contact points at the PV label 3 at the place of the honeycomb mesh cut-out 26. Preferably, the cut-out 26 in the honeycomb structure 18 offers the same outer shape as the related electrical connection box 36, to ensure that assembly workers cannot attach the electrical connection box 36 in a wrong orientation. Furthermore, the cut-out 26 is dimensioned such as to allow for some positional tolerances.

Fig. 4 shows another constructive adaptation of a photovoltaic sandwich panel 1. According to this embodiment of the invention, the photovoltaic sandwich panel 1 comprises at least one filled-up honeycomb cell 28. Such filled-up honeycomb cell 28 has a same outer contour as other honeycomb cells in the honeycomb structure 18. However, in contrast to the majority of the honeycomb cells in the honeycomb structure 18 not being filled but including side walls surrounding an empty volume, the filled-up honeycomb cells 28 are filled-up with polymeric material and thereby form a planar continuous layer portion being in one piece with the back structure 5. In some places, brackets or other parts need to be glued to the back structure 5 in a place where the non-planar general honeycomb structure 18 would hinder it. The planar filled-up honeycomb cell 28 allows a proper connection surface at this position.

Fig. 5 shows another embodiment of the inventive photovoltaic sandwich panel 1. In this case, the photovoltaic sandwich panel 1 consists of three PV-labels 3a, 3b, 3c fixed with one back structure 5. Accordingly, the frame structures 22a, 22b, 22c and the pockets structures 24a, 24b, 24c of the back structure 5 are arranged circumferential to the outer edge of each PV label 3a, 3b, 3c. Furthermore, the back structure 5 comprises an area with an interface geometry 30 with locator pins and blind holes. The pocket structures 24a, 24b are accordingly adapted around the interface geometry 30.

It is to be noted that the PV sandwich panel 1 proposed herein may be implemented in various variations and the above exemplary embodiments shall be interpreted as forming only specific examples of such variations. Particularly, characteristics of the PV label 1 and, more particularly, characteristics of the back structure 5, frame structure 22, the pocket structure 24 may deviate from the characteristics mentioned in the above exemplary embodiments.

The PV sandwich panel 1 may be manufactured in various manners.

For example, in a preferred embodiment, the method of manufacturing the photovoltaic sandwich panel 1 is visualized in Fig. 6 and comprises at least the following steps:
- Providing a reversibly closable mould with a cavity formed by a first and a second mould part 38, 40. The mould is suitable for polymeric (reaction) injection molding.
- Inserting at least one sheet-like photovoltaic label 3 into the first mould part 38. Accordingly, the PV label 3 is arranged within the cavity to be formed between the first and a second mould parts 38, 40. The PV label 3 comprises a front side polymeric lamination foil 11, a rear side polymeric lamination foil 13, optionally one or more stabilisation foils and a solar cell arrangement 17 interposed between the front and rear side lamination foils 11, 13.

- Closing the mould via pressing the first mould part 38 and the second mould part 40 together and thereby fixing the at least one sheet-like PV label 3 between the first and second mould parts 38, 40 by applying a frictional connection to the photovoltaic label 3. Therein, the frictional connection is basically applied by multiple pocket-stamps 32 positioned in a circumferential area of a frame structure 22, at a circumferential outer edge of the at least one PV label 3 outside the solar cell arrangement 17.
- Injecting a viscous polymer material into the cavity and onto the at least one PV label 3 and subsequently solidifying the polymer material, thereby creating and fixing a back structure 5 to the at least one PV label 3.

Therein, the first and second mould parts 38, 40 have a form and contour including multiple pocket-stamps 32 and multiple honeycomb-stamps 34. The pocket-stamps 32 are arranged along a line at a periphery of the mould close to an outer circumference. The honeycomb-stamps 34 are arranged in a central area of the mould which is surrounded by the line of pocket-stamps 32. Accordingly, the first and second mould parts 38, 40 with their pocket-stamps 32 and honeycomb-stamps 34 form a cavity which, when being filled with injected polymer material and subsequently solidified, forms the back structure 5 comprising the honeycomb structure 18, at areas of the PV label 3 which comprise the solar cell arrangement 17, and comprising a frame structure 22, at parts of the PV label 3 without the solar cell arrangement 17. Therein, the frame structure 22 is basically arranged circumferential of the outer edge of the PV label 3. Furthermore, the pocket-stamps 32 being provided at one of the first and second mould parts 38, 40 have a height being larger than a height of the honeycomb-stamps 34, i.e. protruding slightly further towards the other one of the first and second mould parts 38, 40. Accordingly, upon the mould being closed and the first and second mould parts 38, 40 being pressed towards each other, the pocket-stamps 32 strongly press onto the circumferential edge area of the PV label 3, thereby compressing and reliably fixing it in the mould during the highly pressurized polymer injection process.

Preferably, the back structure 5 including the honeycomb structure 18 and the frame structure 22 is created with a single common injection of viscous polymer material into the cavity of the mold.

Finally, it should be noted that the term "comprising" does not exclude other elements or steps and the "a" or "an" does not exclude a plurality. Also, elements described in association with different embodiments may be combined. It should also be noted that reference signs in the claims should not be construed as limiting the scope of the claims.

### LIST OF REFERENCE SIGNS

- 1: PV sandwich panel
- 3: sheet-like photovoltaic label
- 5: back structure
- 11: front side polymeric lamination foil
- 13: rear side polymeric lamination foil
- 15: solar cell
- 17: solar cell arrangement
- 18: honeycomb structure
- 19: mesh size
- 20: rib height
- 21: rib width
- 22: frame structure
- 23: frame width
- 24: pocket structure
- 25: runner
- 26: cut-out in a honeycomb mesh
- 28: filled-up honeycomb cell
- 30: interface geometry
- 32: pocket-stamp
- 34: honeycomb-stamp
- 36: electrical connection box
- 38: first mould part
- 40: second mould part

## Claims

1. Photovoltaic sandwich panel (1), particularly photovoltaic vehicle cladding sandwich panel, comprising:
sheet-like photovoltaic label (3), and
a back structure (5),
wherein one photovoltaic label (3) comprises at least a front side polymeric lamination foil (11), a rear side polymeric lamination foil (13) and a solar cell arrangement (17) interposed between the front and rear side lamination foils (11, 13),
wherein photovoltaic label (3) is fixed with its rear side to a front side of the back structure (5),
wherein the back structure (5) comprises a honeycomb structure (18) and a frame structure (22) in one piece,
wherein the frame structure (22) predominantly frames an outer edge of the honeycomb structure (18), and the honeycomb structure (18) is arranged predominantly abutting to an area photovoltaic label (3) which comprises the solar cell arrangement (17), and wherein
the frame structure (22) further comprises a pocket structure (24) which is arranged predominantly abutting to a circumferential outer edge photovoltaic label (3) outside the solar cell arrangement (17).

2. Photovoltaic sandwich panel (1) according to claim 1, wherein the honeycomb structure (22) is designed with a mesh size (19) of approximately 30 mm diameter, a rib width (21) of approximately 3.0 mm and a rib height (20) of approximately 3.7 mm.

3. Photovoltaic sandwich panel (1) according to claim 1, wherein the honeycomb structure (22) is designed with a mesh size (19) of approximately 40 mm diameter, a rib width (21) of approximately 3.0 mm and a rib height (20) of approximately 3.0 mm.

4. Photovoltaic sandwich panel (1) according to one of the preceding claims, wherein the honeycomb structure (18) comprises at least one cut-out (26) in a honeycomb mesh.

5. Photovoltaic sandwich panel (1) according to one of the preceding claims,
wherein at least one honeycomb cell (28) is filled up and thereby is one piece with the back structure (5).

6. Photovoltaic sandwich panel (1) according to one of the preceding claims, wherein the frame structure (22) has a frame width of at least 10 mm.

7. Method for manufacturing a photovoltaic sandwich panel (1), particularly a photovoltaic car body panel, the method comprising:
- providing a reversibly closable mould with a cavity formed by a first mould part (38) and a second mould part (40), suitable for injection moulding,
- inserting a sheet-like photovoltaic label (3) into the first mould part (38), the photovoltaic label (3) comprising a front side polymeric lamination foil (11), a rear side polymeric lamination foil (13) and a solar cell arrangement (17) interposed between the front and rear side lamination foils (11, 13),
- closing the mould via pressing the first mould part (38) and the second mould part (40) together and thereby fixing the sheet-like photovoltaic label (3) between the first and second mould part (38, 40) by applying a frictional connection to the photovoltaic label (3), wherein the frictional connection is basically applied by multiple pocket-stamps (32) positioned in a circumferential frame area, at a circumferential outer edge of the photovoltaic label (3) outside the solar cell arrangement (17)
- injecting a viscous polymer material into the cavity and onto the photovoltaic label (3) and subsequently solidifying the polymer material, thereby creating and fixing a back structure (5) to the photovoltaic label (3), the back structure (5) comprising a honeycomb structure (18), at areas of the photovoltaic label (3) which comprise the solar cell arrangement (17), and comprising a frame structure (22), at parts of the photovoltaic label (3) outside solar cell arrangement (17), wherein the frame structure (22) is arranged at the circumferential outer edge of the photovoltaic label (3).

8. Method according to claim 7, wherein the back structure (5) including the honeycomb structure (18) and the frame structure (22) is created with a single common injection of viscous polymer material into the cavity of the mould.
